# EUROPÄISCHE PATENTANMELDUNG

(11) **EP 0 762 818 A2**
(43) Veröffentlichungstag der Anmeldung: **12.03.1997**
(21) Anmeldenummer: 96114209.8
(22) Anmeldetag: 05.09.1996
(51) Int. Cl.: H05K 7/14, H01R 23/72

(54) **Vorrichtung zur Herstellung einer Verbindung mit einer Leiterplatte**

(30) Priorität: 11.09.1995 DE 19533569
(71) Anmelder: International Business Machines Corporation, Armonk, N.Y. 10504 (US)
(72) Erfinder: Spieth, Markus, 71083 Herrenberg (DE); Recktenwald, Willi, 71088 Holzgerlingen (DE); Renner, Andreas, 71067 Sindelfingen (DE); Richter, Stephan, 71032 Böblingen (DE); Rühle, Gerhard, 71067 Sindelfingen (DE)
(74) Vertreter: Rach, Werner, Dr.

(57) **Zusammenfassung**

Die Erfindung betrifft eine Vorrichtung zur Herstellung einer Verbindung zwischen einer Leiterkarte 12 und einer Träger-Leiterplatte 13 mit einem an der Leiterkarte und der Träger-Leiterplatte ausgebildeten Pad-on-Pad Konnektor 14, mit einer im wesentlichen bogenformig gekrümmten Gegenlagerung 15 zur Anpressung der Träger-Leiterplatte an die Leiterkarte und mit Mitteln 16 zur Einleitung einer Anpresskraft in die Gegenlagerung, wobei die Gegenlagerung durch die Anpresskraft elastisch so verformbar ist, daß die Gegenlagerung in einem flächigen Bereich an der Träger-Leiterplatte anliegt.

## Beschreibung

Die Erfindung betrifft eine Vorrichtung zur Herstellung einer elektrischen Verbindung.

An elektrische Verbindungen, insbesondere Steckverbindungen, werden in der Praxis hohe Anforderungen gestellt, denn sie müssen unter verschiedenen Belastungen, wie z.B. Schwingungen, Temperaturunterschiede usw. gewährleisten, daß die durch die Steckverbindung hergestellten Kontakte nicht gelöst werden. Des weiteren sollen diese Verbindungen bedienungsfreundlich hinsichtlich des Herstellens und des Lösens der Verbindung sein.

Damit eine Steckverbindung diese Anforderungen erfüllen kann, bedarf sie einer Verriegelungsvorrichtung zum Verschieben und Lösen der Teile der Steckverbindung. Durch eine solche Vorrichtung wird sichergestellt, daß alle Kontakte geschlossen werden und zum anderen, daß diese Kontakte sich nicht von selbst während des Betriebes lösen.

In der europäischen Patentanmeldung EP 03 69 025 ist eine Vorrichtung beschrieben, mit der Karten mit der Platine verbunden und wieder gelöst werden können. Die Vorrichtung besteht aus einem elastischen Rastteil, das mit der Karte verbunden ist, wobei das Rastteil ein bewegliches Endteil aufweist und einen Bedienungshebel, der drehbar an der Karte gelagert ist. Bedienungshebel und Rastteil sind so zueinander angeordnet, daß beim Drehen des Bedienungshebels das Rastteil aufgrund der gekrümmten Oberfläche des Bedienungshebels eine translatorische Bewegung ausführt, wodurch eine Verbindung zwischen Karte und Platine hergestellt wird. Ist eine wirksame Verbindung hergestellt, fällt das bewegliche Endteil in eine am Bedienungshebel vorgesehene Nut ein und verharrt in dieser Position, wodurch die Karte in dieser Position fixiert wird.

Ein Nachteil dieser Vorrichtung liegt insbesondere darin, daß der durch die Einschubkraft ausgeübte Druck dauernd auf der Platine lastet, so daß die Platine während der Verbindung mit der Karte unter starker Spannung steht. Außerdem läßt es sich nicht ausschließen, daß die Einschubkraft aufgrund der vielen Kontakte, die durch die Steckverbindung hergestellt werden müssen, so groß ist, daß sich die Platine durchbiegt. Eine dauerhafte Durchbiegung der Platine führt aber zu Rissen auf der Platine, so daß die aufgedruckten Leitungen zerstört werden. Ein weiterer Nachteil dieser Vorrichtung ergibt sich daraus, daß aufgrund der vorgenannten Probleme die Anzahl der Kontakte, die durch eine Steckverbidnung hergestellt werden können, begrenzt ist, d.h. daß große Karten mit sehr vielen Kontakten mit dieser Vorrichtung nicht verriegelt werden können. Die Funktionen müssen daher auf mehreren Karten verteilt werden, was zu größeren Gehäusen führt.

Eine Vorrichtung der eingangs genannten Art zum Verriegeln und Lösen einer Verbindung für elektrische Steckkontakte ist in dem IBM Technical Disclosure Bulletin, Vol. 31, No. 11, April 1989, S. 76-80, beschrieben. Diese Vorrichtung besteht aus Rasthebeln, die an der oberen und unteren Ecke der Karte oder des Schutzgehäuses angeordnet sind, und aus Sperren, die am Gehäuse befestigt sind. Jedem Rasthebel ist eine Sperre funktional derart zugeordnet, daß der Rasthebel erst dann in Eingriff mit der Sperre kommen kann, wenn eine wirksame Verbindung zwischen Karte und Platine hergestellt worden ist. Ein wesentlicher Nachteil dieser Vorrichtung besteht darin, daß der Druck, der zum Verbinden der Karte mit der Platine erforderlich ist, während des gesamten Betriebes auf den Teilen der Steckverbindung lastet. Im übrigen weist diese Vorrichtung die gleichen Nachteile auf, die bei der europäischen Anmeldung EP 03 69 025 aufgeführt worden sind.

Aus der US 29 93 187 ist eine Vorrichtung bekannt, bei der Rasthebel an am Gehäuse angebrachten, federnden Bügeln angreifen. Durch diese Anordnung können Kräfte quer zur Einschiebevorrichtung auf die Leiterplatte einwirken.

Aus der DE 4042060 C1 ist eine Vorrichtung zum Verbindung und Lösen einer elektrischen Steckverbindung bekannt. Die Vorrichtung besteht aus Rasthebeln, die drehbar am unteren und oberen Eckbereich eines Schutzgehäuses bzw. einer Karte angeordnet sind, und flexibel ausgestalteten Teilen, insbesondere Federn, die entweder an einem unflexiblen Sperrteil oder direkt am Gehäuse befestigt sind. An den flexiblen Teilen befindet sich ein Mitnehmerteil.

Den vorbekannten Vorrichtungen ist der Nachteil gemeinsam, daß damit nur eine relativ begrenzte Anzahl von Verbindungen herstellbar ist. Insbesondere bei Steckverbindungen tritt nämlich das Problem auf, daß bei einer zunehmenden Anzahl der Kontaktstifte die aufzubringende Einschubkraft wächst. Die Einschubkraft darf jedoch ein zulässiges Höchstmaß nicht überschreiten, um eine Beschädigung der Leiterplatten zu vermeiden und auch, um eine aufwändige mechanische Konstruktion zur Aufbringung der erforderlichen Einschubkraft einzusparen. Beispielsweise ist die maximale Anzahl von Verbindungen, die mit der aus der DE 40 42 060 bekannten Vorrichtung herstellbar sind, 600 Verbindungen für eine Leiterplatte.

Figur 1 zeigt eine solche aus der DE 40 42 060 bekannte Vorrichtung. Wie Figur 1 zeigt, werden eine oder mehrere Karten 3 parallel nebeneinander in ein Gehäuse 1 eingeführt und innerhalb des Gehäuses 1 mit einer Platine 5 verbunden. Die Karten 3, insbesondere wenn es sich um elektronische Karten handelt, werden üblicherweise in einem Schutzgehäuse 6 zum Schutz gegen elektromagnetische Strahlung gelagert. Dieses Schutzgehäuse 6 ist so gestaltet, daß es eine Öffnung aufweist, aus denen ein Kontaktverbindungsteil 4 herausragt, das mit einem Kontaktverbindungsteil 7 der Platine 5 verbunden wird. Am Schutzgehäuse 6 befindet sich an einer Seite in der oberen und unteren Ecke jeweils ein Rasthebel 9, die schwenkbar am Schutzgehäuse 6 gelagert sind. Soweit aus technischen Gründen auf das Schutzgehäuse 6 zur Abschirmung der Karte 3 verzichtet werden kann, ist die Befestigung des Rasthebels 9 direkt an der Karte 3 möglich.

An dem Gehäuse 1 befindet sich jeweils im oberen und unteren Bereich Sperren 11, in die die Rasthebel 9 erst dann eingreifen können, wenn eine wirksame Verbindung zwischen dem Kontaktverbindungsteil 7 der Platine 5 und dem Kontaktverbindungsteil 4 der Karte 3 hergestellt worden ist. Die Sperren 11 können einzeln oder gemeinsam an einem Teil befestigt, am Gehäuse 1 angebracht sein.

Das Kontaktverbindungsteil 4 kann beispielsweise ein sogenannter 600-Pin Konnektor sein. Eine Erhöhung der Anzahl der Pins über 600 hinaus würde eine zu große Steckkraft erforderlich machen, die durch Muskelkraft nicht mehr aufbringbar wäre und außerdem die Karte 3 oder deren Gehäuse 6 beschädigen könnte.

Auf Leiterplatten werden zunehmend hochkomplexe Schaltkreise untergebracht, die eine große Anzahl von Verbindungen zur Kommunikation mit der Umgebung, insbesondere mit anderen Leiterplatten, erfordern.

Der Erfindung liegt daher die Aufgabe zugrunde, eine Vorrichtung zur Herstellung einer Verbindung zu schaffen, die die Herstellung einer größeren Anzahl von Verbindungen zwischen einer Leiterkarte und einer Träger-Leiterplatte ermöglicht.

Das der Erfindung zugrundeliegende Problem wird durch die Merkmale der unabhängigen Ansprüche gelöst.

Im Gegensatz zu der im Stand der Technik verwendeten "Pin-and-Hole" Technologie, kommen bei der erfindungsgemäßen Vorrichtung "Pad-on-Pad" Konnektoren zum Einsatz. Bei Pad-on-Pad Konnektoren wird der elektrische Kontakt über eine Berührungsfläche hergestellt, während bei der herkömmlichen Pin-and-Hole Technologie das Einführen eines Kontaktstiftes in einen entsprechenden Stecker erforderlich ist. Pad-on-Pad Konnektoren als solche sind aus dem Stand der Technik für das sogenannte Module Packaging bekannt sowie für die Verbindung von Kabeln (IBM TDB Vol. 37, Nr. 11, November 1994, Seiten 581-584, IBM Research Disclosure, Nr. 346, Februar 1993, J.L. Rice and F. H. Smith, TDB Nr. 6, November 1992, Seiten 259-260 and TDB März 1985, Seiten 5962-5965 sowie TDB Nr. 6, November 1992, Seiten 259-260).

Durch den Einsatz von Pad-on-Pad Konnektoren wird die zur Herstelung einer Verbindung zwischen einer Leiterkarte und einer Träger-Leiterplatte erforderliche Einschubkraft minimiert. Das ist vor allem dadurch bedingt, daß die Reibung der Kontaktstifte beim Einstecken in den Gegenstecker entfällt. Die Anzahl der zwischen einer Leiterkarte und einer Träger-Leiterplatte herstellbaren Verbindungen ist deshalb nicht - wie im Stand der Technik - aufgrund der Reibungskräfte auf ca. 600 beschränkt, sondern kann auch zum Beispiel 1800 Verbindungen zur Signalübertragung betragen.

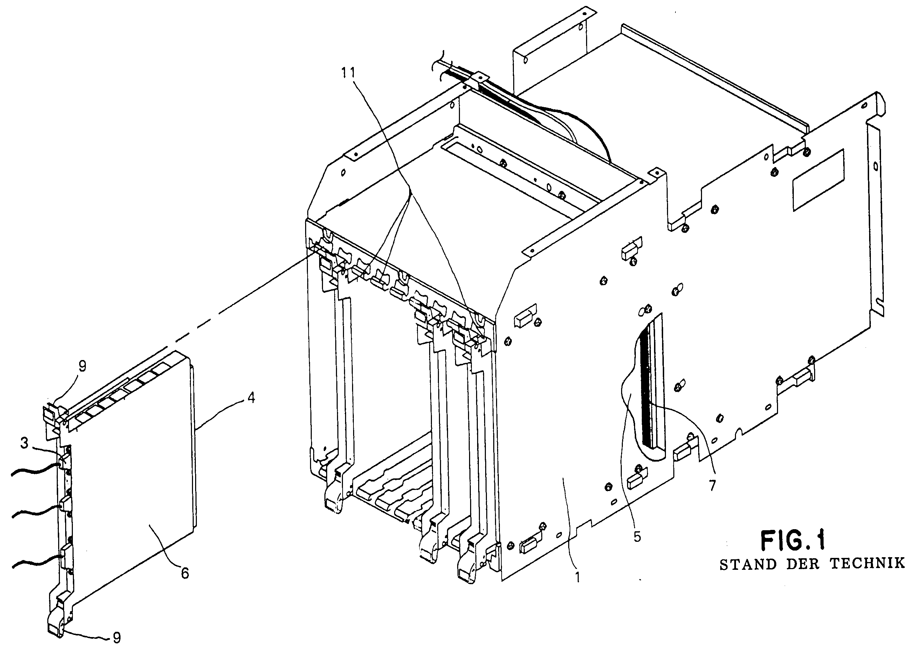

Überdies erlauben Pad-on-Pad Konnektoren eine kompaktere Bauform im Vergleich zu Pin-and-Hole Konnektoren. Deshalb können Leiterkarten und Träger-Leiterplatten, die mit einer erfindungsgemäßen Vorrichtung ausgestattet sind, die gleiche Baugröße haben, wie mit Pin-and-Hole Konnektoren ausgestattete Leiterkarten, obwohl die erfindungsgemäßen Leiterkarten z. B. eine doppelte Anzahl von Signalausgängen aufweisen. Die erfindungsgemäßen Leiterplatten können deshalb so konstruiert werden, daß sie kompatibel sind zu dem in der Fig. 1 gezeigten mechanischen Aufbau.

Besonders vorteilhaft ist die Verwendung einer kreisbogenförmig gekrümmten Gegenlagerung zur Anpressung der Träger-Leiterplatte an die Leiterplatte. Wenn die Krümmung der Gegenlagerung der Elastizität des Materials der Gegenlagerung und der Anpresskraft entsprechend gewählt ist, verformt sich die Gegenlagerung bei Einleitung einer Anpresskraft gerade so, daß die Gegenlagerung ihrer gesamten Länge nach an der Träger-Leiterplatte anliegt. Dann ist ein besonders sicherer Kontakt der Leiterplatte und der Träger-Leiterplatte über die Pad-on-Pad Konnektoren sichergestellt.

Die Gegenlagerung kann an der Träger-Leiterplatte mittels elastischer Elemente mit Spiel aufgehängt sein. Das erweist sich bei der Justage der Leiterkarte and der Träger-Leiterkarte während des Einschiebens als vorteilhaft. Die Selbst-Justage wird dadurch unterstützt. Ein weiterer Vorteil der eleastischen Aufhängung ist die Dämpfung von Stößen beim Transport der Träger-Leiterkarte mit der eingebauten Leiterplatte. Die mechanische Belastung der Leiterplatte und damit auch der Träger-Leiterkarte wird dadurch verringert.

Ein Ausführungsbeispiel der Erfindung ist in der Zeichnung dargestellt und wird im folgenden näher beschrieben.

Es zeigen
- Fig. 1: eine perspektivische Ansicht einer Karte und eines Gehäuses zur Aufnahme mehrerer solcher Karten nach dem Stand der Technik.
- Fig. 2: eine perspektivische Ansicht einer erfindungsgemäßen Vorrichtung an einer Leiterkarte und einer Träger-Leiterplatte.
- Fig. 3: die Gegenlagerung in perspektivischer Ansicht,
- Fig. 4: die Anordnung der Pad-on-Pad Konnektoren auf der Leiterkarte.

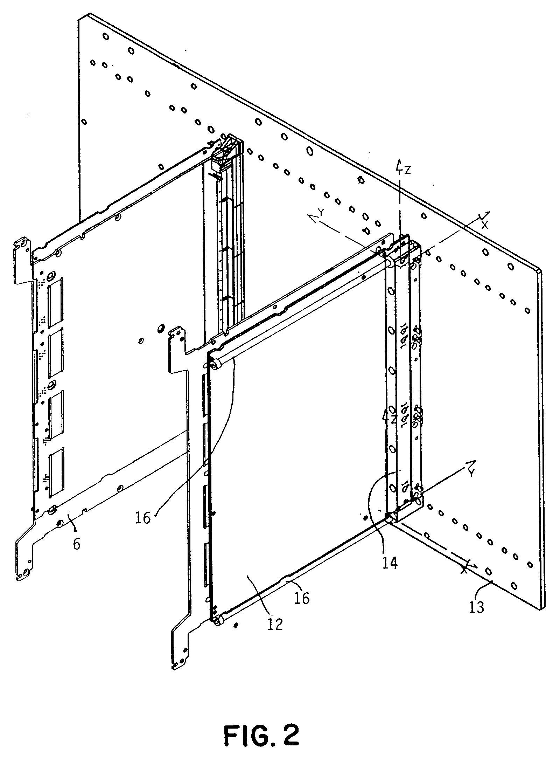

Neben einer aus dem Stand der Technik bekannten Karte 6 (vgl. Fig. 1) ist in der Fig. 2 eine Leiterkarte 12 dargestellt, die einen Pad-on-Pad Konnektor 14 aufweist. Das Gegenstück zu dem Pad-on-Pad Konnektor 14 befindet sich an der Träger-Leiterplatte 13. Die Träger-Leiterplatte 13 entspricht der Platine 5 der Fig. 1, die jedoch lediglich Pin-and-Hole Konnektoren aufweist. Die Karte 6 ist an der Träger-Leiterplatte 13 - wie aus dem Stand der Technik bekannt - mittels eines Pin-and-Hole Konnektors kontaktiert.

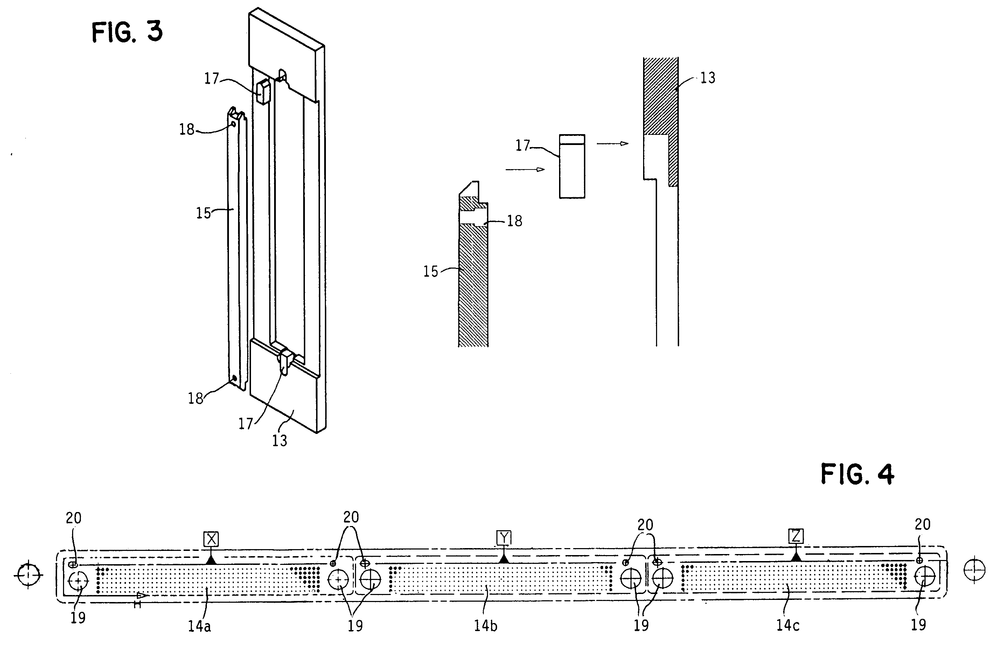

Dagegen wird die Verbindung zwischen der Leiterkarte 12 und der Trägerleiterkarte 13 erfindungsgemäß durch einen Pad-on-Pad Konnektor 14 hergestellt. In diesem Ausführungsbeispiel besteht der Pad-on-Pad Konnektor 14 aus insgesamt 3 nebeneinander angeordneten Einzelkonnektoren (vgl. Fig. 4).

Mittels der Schrauben 16 werden der Konnektor 14 und sein an der Träger-Leiterplatte 13 befindliches Gegenstück aneinandergepresst, um eine sichere Kontaktierung zu gewährleisten. Durch die Schrauben 16 wird dabei eine Anpresskraft in die an der Träger-Leiterplatte 13 befindliche Gegenlagerung 15 eingeleitet (vgl. Fig. 3).

Im übrigen entspricht der mechanische Aufbau dem in der Fig. 1 gezeigten Aufbau. Insbesondere weisen die einzelnen Leiterplatten 12 auch Rasthebel 9 auf.

Fig. 3 zeigt die Gegenlagerung 15, und einen Ausschnitt aus der Träger-Leiterplatte 13. Die Gegenlagerung 15 wird im zusammengebauten Zustand an der Träger-Leiterplatte 13 mittels elastischer Elemente 17 fixiert. Die elastischen Elemente 17 können beispielsweise aus Kunststoff bestehen. Die Gegenlagerung 15 ist kreisbogenförmig gekrümmt. Der Radius des Kreisbogens ist wesentlich größer als dessen Länge. Der Kreismittelpunkt liegt auf der der Leiterkarte 12 abgewandten Seite.

Die Bohrungen 18 in der Gegenlagerung 15 sind mit einem Innengewinde versehen. Zur Herstellung einer Verbindung zwischen der Leiterkarte 12 und der Träger-Leiterplatte 13 wird zunächst die Leiterplatte 12 in ein Gehäuse eingeschoben, das dem Gehäuse 1 der Fig. 1 entspricht. Durch Betätigung der Rasthebel 9 wird die Leiterkarte 12 bezüglich der Träger-Leiterplatte 13 vorjustiert. Danach werden die Schrauben 16 in die Bohrungen 18 in der Gegenlagerung 15 geschraubt. Dadurch wird eine Anpresskraft in die Gegenlagerung 15 eingeleitet. Gleichzeitig wird der Pad-on-Pad Konnektor 14 bezüglich seines Gegenstücks an der Träger-Leiterplatte 13 während des Festschraubens feinjustiert.

Bei der in der Zeichnung dargestellten bevorzugten Ausführungsform der Erfindung wird die Vor- und Feinjustage durch die kegelförmigen Elemente 19 bzw. 20 unterstützt (Fig. 4). Die kegelförmigen Elemente 19 und 20 befinden sich an den Einzelkonnektoren 14a, 14b, 14c. Die Elemente 19 und 20 sind zylinderförmig mit einem Kegelstumpfaufsatz, also wie ein angeschrägter Bolzen geformt. Die Elemente 19 sind leicht beweglich schwimmend gehalten, so daß sie ein seitliches Spiel ermöglichen. Die Elemente 20 dagegen sind fest an den Einzelkonnektoren 14a, 14b, 14c fixiert. Den Einzelkonnektoren 14a, 14b, 14c entsprechen Konnektoren auf der Träger-Leiterplatte 13, über die die Signalverbindungen hergestellt werden. Fig.4 zeigt daher quasi einen Abdruck - sog. foot print - der entsprechenden Konnektoren der Träger-Leiterplatte 13.

Beim Einschieben der Leiterkarte 12 in die Träger-Leiterplatte 13 werden die kegelförmigen Elemente 19 in Aufnahmebohrungen der Träger-Leiterplatte 13 eingeführt. Dies wird durch das seitliche Speil der Elemente 19 erleichtert. Durch die Einführung der kegelförmigen Elemente 19 in ihre entsprechenden Aufnahmebohrungen werden die Konnektoren 14a, 14b, 14c auf ihre entsprechenden Gegenstücke vorjustiert. Die Feinjustage erfolgt dann bei Einführung der Elemente 20 in deren entsprechende Aufnahmebohrungen. Dies geschieht zeitlich nach der Vorjustage, da die Elemente 20 eine geringere Höhenausdehnung als die Elemente 19 aufweisen.

## Patentansprüche

1. Vorrichtung zur Herstellung einer Verbindung zwischen einer Leiterkarte(12)und einer Träger-Leiterplatte (13)
mit einem an der Leiterkarte und der Träger-Leiterplatte ausgebildeten pad-on-pad Konnektor(14),
mit einer im wesentlichen bogenförmig gekrümmten Gegenlagerung(15) zur Anpressung der Träger-Leiterplatte an die Leiterkarte und
mit Mitteln (16) zur Einleitung einer Anpreßkraft in die Gegenlagerung.

2. Vorrichtung nach Anspruch 1 wobei die Gegenlagerung im wesentlichen kreisbogenförmig gekrümmt ist, wobei die Gegenlagerung durch die Anpreßkraft plastisch so verformbar ist, daß die Gegenlagerung in einem flächigen Bereich an der Träger-Leiterplatte anliegt.

3. Vorrichtung nach Anspruch 2 wobei der Radius des Kreisbogens der Gegenlagerung wesentlich größer ist als die Abmessungen der Gegenlagerung.

4. Vorrichtung nach einem der vorhergehenden Ansprüche wobei die Krümmung der Gegenlagerung deren Elastizität entspricht, so daß bei Einleitung einer vorgegebenen Anpreßkraft die Gegenlagerung so verformt wird, daß die Gegenlagerung flächig an der Träger-Leiterplatte anliegt.

5. Vorrichtung nach einem der vorhergehenden Ansprüche wobei die Gegenlagerung stabförmig ausgebildet ist.

6. Vorrichtung nach einem der vorhergehenden Ansprüche wobei die Anpreßkraft mittels Schrauben in einem Randbereich der Gegenlagerung eingeleitet wird und die Leiterplatte als auch die Träger-Leiterplatte Bohrungen zur Aufnahme der Schrauben aufweisen.

7. Vorrichtung nach einem der vorhergehenden Ansprüche wobei der pad-on-pad Konnektor aus mehreren, vorzugsweise drei Einzelkonnektoren oder - insbesondere bei vor- und rückseitiger Bestückung - aus sechs Einzelkonnektoren besteht.

8. Computersystem mit einer Leiterplatte, einer Träger-Leiterkarte und einer Vorrichtung nach einem der vorhergehenden Ansprüche.

9. Verfahren zur Herstellung einer Verbindung zwischen einer Leiterkarte(12)und einer Träger-Leiterplatte (13) über einem an der Leiterkarte und der Träger-Leiterplatte ausgebildeten pad-on-pad Konnektor(14) gekennzeichnet durch folgenden Schritt:
Anpressung der Leiterplatte an die Träger-Leiterplatte durch eine im wesentlichen bogenförmig gekrümmte Gegenlagerung(15), wobei die Gegenlagerung durch die Anpreßkraft elastisch so verformt wird, daß die Gegenlagerung in einem flächigen Bereich an der Träger-Leiterplatte anliegt.
